# EUROPÄISCHE PATENTANMELDUNG

(11) **EP 2 730 930 A2**
(43) Veröffentlichungstag der Anmeldung: **14.05.2014**
(21) Anmeldenummer: 13005343.2
(22) Anmeldetag: 13.11.2013
(51) Int. Cl.: G01R 15/20

(54) **Flusskonzentrator für eine Sensoranordnung sowie eine entsprechende Sensoranordnung und eine Steckdose**

(30) Priorität: 13.11.2012 DE 102012110869
(71) Anmelder: GIRA GIERSIEPEN GmbH & Co. KG, D-42477 Radevormwald (DE)
(72) Erfinder: Nott, Werner, 9342 Gurk (AT)
(74) Vertreter: Angerhausen, Christoph

(57) **Zusammenfassung**

Die Erfindung betrifft einen Flusskonzentrator (1) für eine Sensoranordnung, der einen Durchlass (2) für einen elektrischen Leiter (3) und ein Wandelement (a, b, c, d) aufweist, das durch einen Spalt (4) zur Aufnahme eines Hall-Sensor (5) unterbrochen und in zwei beabstandete Hälften unterteilt ist, wobei die Hälften den Spalt (4) mit parallel beabstandeten Stirnflächen (6) begrenzen, dadurch gekennzeichnet, dass die Stirnflächen (6) größer sind als eine Querschnittsfläche des Wandelements (a, b, c, d), das durch den Spalt (4) unterteilt ist, in Richtung senkrecht zu einer Außenseite (7) des Flusskonzentrators (1).

## Beschreibung

Die Erfindung betrifft einen Flusskonzentrator für eine Sensoranordnung sowie eine entsprechende Sensoranordnung und eine Steckdose, wobei der Flusskonzentrator einen Durchlass für einen elektrischen Leiter und ein Wandelement aufweist, das durch einen Spalt zur Aufnahme eines Hall-Sensors unterbrochen und in zwei beabstandete Hälften unterteilt ist, wobei die Hälften den Spalt mit parallel beabstandeten Stimflächen begrenzen. Ein derartiger Flusskonzentrator sowie eine entsprechende Sensoranordnung sind aus der DE 100 386 45 A1 bekannt.

Bei der Strommessung mithilfe von Hall-Sensoren wird unter Ausnutzung des Hall-Effekts der magnetische Fluss um einen elektrischen Leiter gemessen, welcher proportional zu dem durch den Leiter geführten elektrischen Strom ist. Da die durch den Stromffuss hervorgerufene magnetische Flussdichte nicht unmittelbar an der Leiteroberfläclte gemessen werden kann, ist es zur Bündelung des magnetischen Flusses bekannt, unter einem Abstand zu dem Leiter um den Leiter herum einen ringförmigen Flusskonzentrator anzuordnen. Häufig werden dazu geschlitzte, ringförmige Flusskonzentratoren verwendet, wie sie auch aus der DE 100 386 45 A1 bekannt sind.

Da Flusskonzentratoren und die entsprechenden Sensoranordnungen häufig in elektronischen Bauteilen unter beengten Platzverhältnissen verbaut werden sollen, besteht ein Bestreben dahingehend, die Geometrie des Flusskonzentrators danach auszuwählen, dass er die Herstellung möglichst kompakt bauender Sensoranordnngen erlaubt. Die aus dem Stand der Technik bekannten Flusskonzentratoren sind häufig ringförmige und bis auf den Spalt in sich geschlossene Objekte, die einen Durchlass für den elektrischen Leiter aufweisen, wobei nicht nur kreisförmige Flusskonzentratoren bekannt sind, sondern beispielsweise auch solche, die einen rechteckigen Äußenumfang und einen entsprechenden rechteckigen Durchlass für den elektrischen Leiter aufweisen. Obwohl kreisförmige Flusskonzentratoren aufgrund der näherungsweise kreisförmigen Ausbreitung des magnetischen Flusses um einen zylindrischen Leiter am besten geeignet sind, kann es für die Herstellung platzsparender Sensoranordnungen zweckmäßig sein, einen Flusskonzentrator zu verwenden, welcher eine von der Kreisform abweichende Geometrie aufweist.

Damit der Flusskonzentrator seine den magnetischen Fluss konzentrierende Funktion beibehält und der magnetische Fluss möglichst verlustfrei den Spalt passieren kann, sind der Variation der Geometrie des Flusskonzentrators jedoch Grenzen gesetzt.

Gleichzeitig kann auch der Miniaturisierung der Hall-Sensoren, welche in dem Spalt aufgenommen werden sollen, nicht beliebig vorangetrieben werden, wenn hohe Anforderungen an den Fehler des Messergebnisses gestellt werden. Je nach Messbereich und Anforderungsprofil einer Anwendung muss der Spalt daher eine gewisse Mindestquerschnittsfläche und gewisse Mindestabmessungen aufweisen.

Es ist daher die Aufgabe der Erfindung, einen Flusskonzentrator für eine Sensoranordnung der eingangs genannten Art derart weiter zu entwickeln, dass er für die Bereitstellung einer möglichst platzsparenden Sensoranordnung geeignet ist

Diese Aufgabe wird erfindungsgemäß durch einen Flusskonzentrator gemäß dem Anspruch 1 gelöst. Der Anspruch 9 betrifft eine entsprechende Sensoranordnung und der Anspruch 11 eine entsprechende Steckdose. Die abhängigen Ansprüche betreffen jeweils vorteilhafte Ausführugsformen der Erfindung.

Der erfindungsgemäße Flusskonzentrator zeichnet sich dadurch aus, dass die Stirnflächen größer sind als eine Querschnittsfläche des Wandelements, das durch den Spalt unterteilt ist, in Richtung senkrecht zu einer Außenseite des Flusskonzentrators. Dies ermöglicht die Verwendung von Hall-Sensoren, die eine Sensorfläche aufweisen, die größer als die Querschnittsfläche des Wandelements senkrecht zu der Außenseite des Flusskonzentrators ist. Andererseits können mit Hilfe des erfindungsgemäßen Flusskonzentrators aufgrund der sich ergebenden größeren Spaltabmessungen größere Teile des Hall-Sensors in dem Spalt aufgenommen werden, wodurch sich die geforderte Platzersparnis ergibt.

Bei der bevorzugten Ausführungsform erstreckt sich der Spalt unter einem Winkel, mit α ≠ 90°, zu einer Außenseite des Flusskonzentrators. Dadurch, dass sich der Spalt unter dem vorgenannten Winkel erstreckt, wird erreicht, dass der Hall-Sensor unter einem entsprechenden Winkel in den Spalt eingesetzt werden kann. Dies ermöglicht, dass die Abmessung der Sensoranordnung in Richtung senkrecht zu der Außenseite kleiner ist, als für den Fall, dass der Sensor in Richtung senkrecht zu der Außenseite in den Spalt eingesetzt ist. Des Weiteren hat dies zur Folge, dass bei gegebener Tiefe des Flusskonzentrators der Spalt in seiner Erstreckungsrichtung eine Länge aufweisen kann, die größer als die Abmessung des Flusskonzentrators senkrecht zu der Außenseite ist.

Bei einer Ausführungsform der Erfindung ist daher vorgesehen, dass der Spalt in seiner Erstreckungsrichtung unter dem Winkel α zu der Tiefenrichtung eine Länge aufweist, die größer als eine Abmessung des Flusskonzentrators in Richtung senkrecht zu der Außenseite ist.

Ein besonders platzsparender Flusskonzentrator kann dadurch erreicht werden, dass er im Wesentlichen quaderförmig ausgebildet ist, und vier Wandelemente aufweist, die den Durchlass umschließen und von denen aneinandergrenzende Wandelemente senkrecht aufeinander stehen, wobei eines der Wandelemente durch den Spalt in zwei parallel beabstandete Hälften unterteilt ist.

Vorzugsweise weist der Flusskonzentrator in zwei Raumrichtungen senkrecht zu einer Tiefenrichtung jeweils eine Abmessung auf, die mindestens dem Doppelten der Abmessung des Flusskonzentrators in Tiefenrichtung entspricht.

Zur Erzielung des möglichst platzsparenden Flusskonzentrators kann der Spalt grundsätzlich unter jedem Winkel α, mit 0 ≠ 90°, zu der Außenseite des Flusskonzentrators ausgerichtet sein. Damit die den magnetischen Fluss konzentrierende Funktionalität des Flusskonzentrators beibehalten wird, und damit gleichzeitig ein möglichst optimaler Wirkungsquerschnitt zu dem in dem Spalt aufgenommenen Hall-Sensor geschaffen wird, ist bei den bevorzugten Ausführungsformen der Erfindung vorgesehen, dass der Winkel α zwischen 30° und 40° und vorzugweise zwischen 34° und 36° beträgt.

Bei der bevorzugten Ausführungsform des erfindungsgemäßen Flusskonzentrators weist dieser eine rechteckige Geometrie auf, wobei auch der Durchlass im Querschnitt rechteckig, vorzugsweise quadratisch ausgebildet sein kann.

Damit die Funktion des Flusskonzentrators, den magnetischen Fluss zu konzentrieren, durch die Anwinklung der Erstreckungsrichtung des Spaltes zu der Außenfläche des Flusskonzentrators nicht beeinträchtigt wird, ist bei einer Ausführungsform der Erfindung vorgesehen, dass den Spalt begrenzende Wandelementhälften jeweils eine Stirnfläche mit einer Strukturierung mit spitzwinkligen Kanten aufweisen.

Die erfindungsgemäße Sensoranordnung umfasst einen Flusskonzentrator gemäß einer der zuvor beschriebenen Ausführungsformen und einen Hall-Sensor, wobei sich der Hall-Sensor in dem Spalt unter demselben Winkel wie der Spalt erstreckt. Bevorzugt weist der Hall-Sensor eine Sensorfläche auf, die größer als die Stirnflächen des Spaltes ist.

Die erfindungsgemäße Steckdose umfasst eine Sensoranordnung der zuvor beschriebenen Art.

Weitere Einzelheiten der Erfindung werden anhand der nachstehenden Figuren erläutert. Dabei zeigt:
- Figur 1: eine perspektivische Darstellung eines erfindungsgemäßen Flusskonzentrators;
- Figur 2: eine Vorderansicht des Flusskonzentrators gemäß Figur 1;
- Figur 3: eine Draufsicht auf die geschlitzte Seite des Flusskonzentrators gemäß den Figuren 1 und 2; und
- Figur 4: eine perspektivische Darstellung einer weiteren Ausführungsform des erfindungsgemäßen Flusskonzentrators mit strukturierten Stirnflächen.

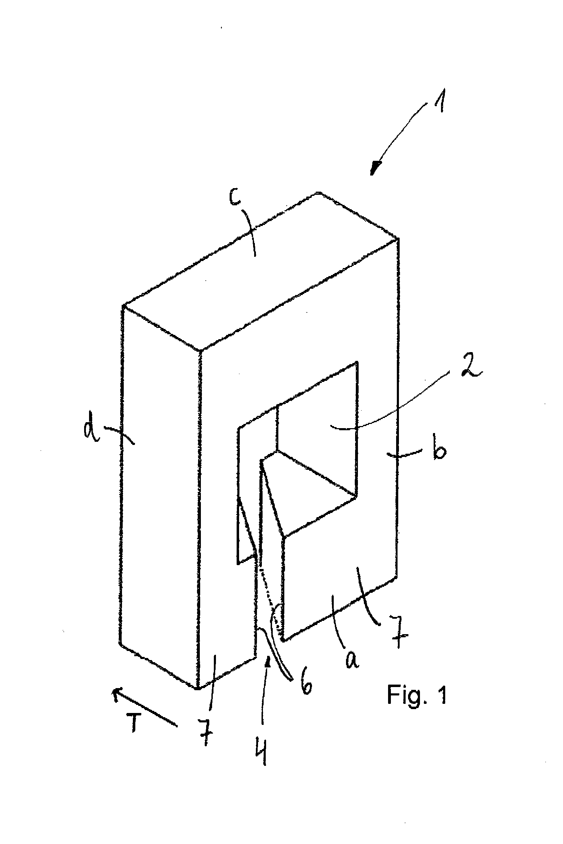

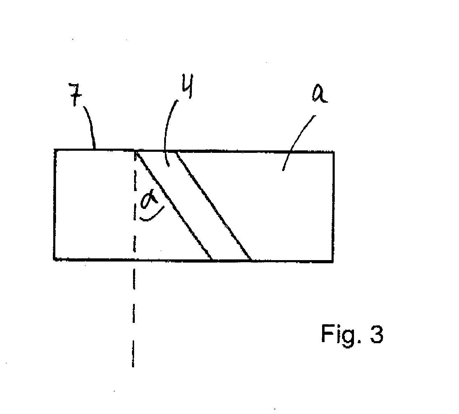

Die Figur 1 zeigt eine beispielhafte Ausführungsform des erfindungsgemäßen Flusskonzentrators 1. Dieser weist einen im Wesentlichen rechteckigen Querschnitt auf und ist in Tiefenrichtung T senkrecht zu dem Querschnitt mit einer konstanten Dicke ausgebildet. Der Flusskonzentrator 1 weist einen quadratischen Durchlass 2 auf. Der Flusskonzentrator 1 ist aus vier Wandelementen a-d zusammengesetzt, wobei jeweils aneinandergrenzende Wandelemente a-d senkrecht aufeinander stehen. Das in der Darstellung unterste Wandelement a weist einen Spalt 4 zur Aufnahme eines Hall-Sensors auf. Wie mit Bezug auf Figur 3 besser zu erkennen ist, erstreckt sich der Spalt 4 unter dem Winkel α zu der Außenseite des Wandelementes a des Flüsskonzentrators 1, wobei der Winkel α von 90° abweichend ist. Dadurch wird erreicht, dass der Spalt 4 in seiner Erstreckungsrichtung unter dem Winkel α zu der Außenseite 7 eine Länge aufweist, die größer als eine Abmessung des Flusskonzentrators in Richtung senkrecht zu der Außenseite 7 und damit in Tiefenrichtung ist. Die hat zur Folge, dass die Stirnflächen 6 größer sind als die Querschnittsfläche des Wandelements a in Richtung senkrecht zu der Außenseite 7 des Flusskonzentrators. Bei gegebener Spaltbreite erhöht sich somit das effektive Spaltvolumen, so dass auch vergleichsweise große Hall-Sensoren in dem Spalt 4 platzsparend aufgenommen werden können. Zugleich ermöglicht die angewinkelte Ausbildung des Spaltes in dem Wandelement a, dass mithilfe des erfindungsgemäßen Flusskonzentrators 1 Sensoranordnungen gebaut werden können, welche in Richtung senkrecht zu der Außenseite 7 weniger ausladend als herkömmliche Sensoranordnungen sind.

Die Zusammenschau der Figuren 1 bis 3 lässt erkennen, dass der Flusskonzentrator 1 gemäß der dargestellten Ausführungsform lediglich senkrecht aufeinander stehende Außenseiten aufweist, mit Ausnahme der Stirnflächen 6, welche den Spalt 4 begrenzen und, wie erfindungsgemäß vorgesehen, unter einem von 90° verschiedenen Winkel zu der Außenseite 7 des Wandelements a und somit unter einem Winkel 180°- α zu der zu der Außenseite 7 parallelen Außenseite des Flusskonzentrators 1 ausgerichtet sind.

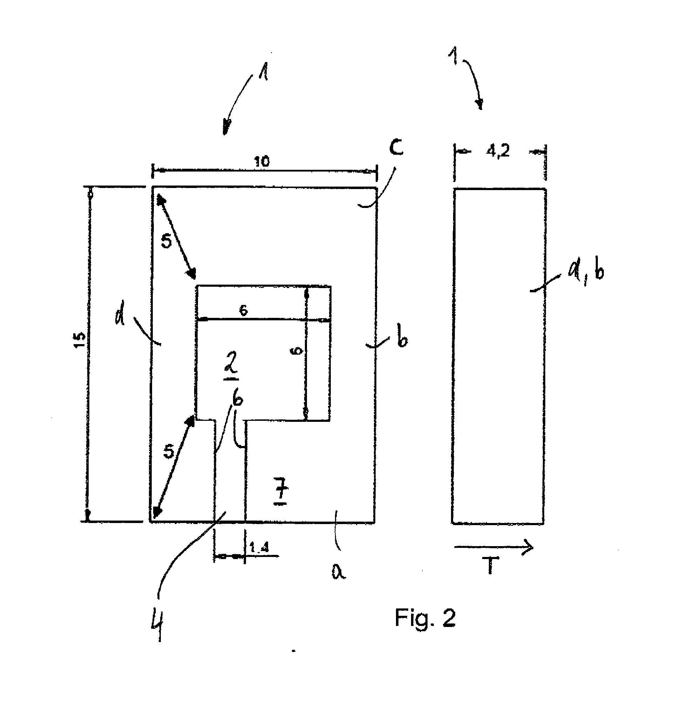

Der erfindungsgemäße Flusskonzentrator 1 ist insbesondere für die Herstellung einer Strommessanordnung für eine Steckdose geeignet, wobei die Integration der Sensoranordnung in eine in ihren wesentlichen Abmessungen durch Normen vordefinierte Steckdose erst dadurch möglich wird, dass die erfindungsgemäße Sensoranordnung platzsparend baut. Es hat sich herausgestellt, dass für Steckdosenanwendungen der erfindungsgemäßen Sensoranordnungen der Flusskonzentrator 1 die in den Figuren 2 und 3 gezeigten Abmessungen aufweisen sollte. Die Abmessungen sind in Millimeter angegeben. Grundsätzlich sollte der Flusskonzentrator 1 in Tiefenrichtung T eine Abmessung von maximal 4 mm und eine Abmessung in Breitenrichtung von maximal 10 mm aufweisen. Ein derartiger Flusskonzentrator 1 ist für Nominalströme bis 16 A und Peakströme bis 80 A geeignet. Das Material C 150-30 hat sich für derartige Anwendungen ganz besonders vorteilhaft herausgestellt.

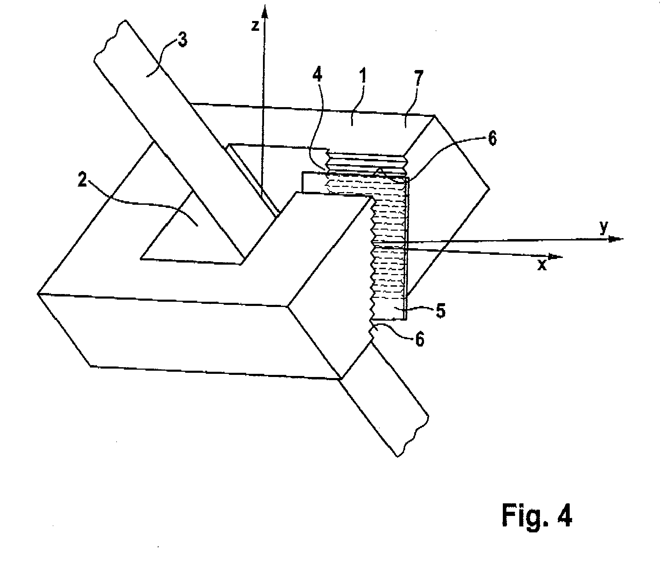

Die Figur 4 zeigt eine Ausführungsform des erfindungsgemäßen Flusskonzentrators, bei der sich durch den Durchlass 2 des Flusskonzentrators 1 ein elektrischer Leiter 3 erstreckt. Um die Durchsetzung des angedeuteten Hall-Sensors 5 mit dem magnetischen Fluss in dem Spalt 4 zu verbessern, indem Streuverluste verringert werden, weisen die Stirnflächen 6 des Flusskonzentrators 1 eine Strukturierung mit spitzwinkligen Kanten auf.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

### BEZUGSZEICHENLISTE:

- 1: Flusskonzentrator
- 2: Durchlass
- 3: elektrischer Leiter
- 4: Spalt
- 5: Hall-Sensor
- 6: Stirnfläche
- 7: Außenseite
- a-d: Wandelement
- T: Tiefenrichtung
- α: Winkel des Spalts zur Tiefenrichtung

## Patentansprüche

1. Flusskonzentrator (1) für eine Sensoranordnung, der einen Durchlass (2) für einen elektrischen Leiter (3) und ein Wandelement (a, b, c, d) aufweist, das durch einen Spalt (4) zur Aufnahme eines Hall-Sensor (5) unterbrochen und in zwei beabstandete Hälften unterteilt ist, wobei die Hälften den Spalt (4) mit parallel beabstandeten Stirnflächen (6) begrenzen, **dadurch gekennzeichnet, dass** die Stirnflächen (6) größer sind als eine Querschnittsfläche des Wandelements (a, b, c, d), das durch den Spalt (4) unterteilt ist, in Richtung senkrecht zu einer Außenseite (7) des Flusskonzentrators (1).

2. Flusskonzentrator (1) nach Anspruch 1, bei dem sich der Spalt (4) unter einem Winkel (α), mit α ≠ 90°, zu der Außenseite (7) des Flusskonzentrators (1) erstreckt.

3. Flusskonzentrator (1) nach Anspruch 2, bei dem der Spalt (4) in seiner Erstreckungsrichtung unter dem Winkel (α) zu der Außenseite (7) eine Länge aufweist, die größer als eine Abmessung des Flusskonzentrators (1) in Richtung senkrecht zu der Außenseite (7) ist.

4. Flusskonzentrator (1) nach einem der vorangegangenen Ansprüche, der im Wesentlichen quaderförmig ist, mit vier Wandelementen (a, b, c, d), die den Durchlass (2) umschließen und von denen aneinander grenzende Wandelemente (a, b, c, d) senkrecht aufeinander stehen, wobei eines der Wandelemente (a, b, c, d) durch den Spalt (4) in zwei parallel beabstandete Hälften unterteilt ist.

5. Flusskonzentrator (1) nach einem der vorangegangenen Ansprüche, der in zwei Raumrichtungen senkrecht zu einer Tiefenrichtung (T) des Flusskonzentrators jeweils eine Abmessung aufweist, die mindestens dem Doppelten der Abmessung des Flusskonzentrators (1) in Tiefenrichtung (T) entspricht.

6. Flusskonzentrator (1) nach einem der vorangegangenen Ansprüche, bei dem der Winkel (α) zwischen 30° und 40° und vorzugsweise zwischen 34° und 36° beträgt.

7. Flusskonzentrator (1) nach einem der vorangegangenen Ansprüche, bei dem der Durchlass (2) im Querschnitt rechteckig, vorzugsweise quadratisch ist.

8. Flusskonzentrator (1) nach einem der vorangegangenen Ansprüche, bei dem die den Spalt (4) begrenzenden Wandelementhälften jeweils eine Stirnfläche (6) mit einer Strukturierung mit spitzwinkligen Kanten aufweisen.

9. Sensoranordnung insbesondere Strommessanordnung, mit einem Flusskonzentrator (1) nach einem der Ansprüche 1 bis 8 und einem Hall-Sensor, wobei sich der Hall-Sensor in dem Spalt (4) unter dem Winkel α zur Außenseite des Flusskonzentrators (1) erstreckt.

10. Sensoranordnung nach Anspruch 9, bei der der Hall-Sensor eine Sensorfläche aufweist, die größer als die Stirnflächen (6) des Spaltes (4) ist.

11. Steckdose, mit einer Sensoranordnung nach Anspruch 9 oder 10.
